(19) Europäisches Patentamt
European Patent Office
Office européen des brevets

(11) **EP 2 553 814 B1**

(12) **FASCICULE DE BREVET EUROPEEN**

(45) Date de publication et mention de la délivrance du brevet:
**02.04.2014 Bulletin 2014/14**

(21) Numéro de dépôt: **11720133.5**

(22) Date de dépôt: **24.03.2011**

(51) Int Cl.:
*H03K 17/66* (2006.01)  *F02D 41/20* (2006.01)

(86) Numéro de dépôt international:
**PCT/FR2011/050634**

(87) Numéro de publication internationale:
**WO 2011/121214 (06.10.2011 Gazette 2011/40)**

(54) **CIRCUIT DE CONTRÔLE DU COURANT DANS UN ORGANE ÉLECTRIQUE DE COMMANDE OU DE LA TENSION AUX BORNES DUDIT ORGANE ÉLECTRIQUE DE COMMANDE**

SCHALTUNG ZUR REGELUNG DES STROMS DURCH EINE STEUERSCHALTUNG ODER ZUR REGELUNG DER SPANNUNG, DIE ÜBER DIESER STEUERSCHALTUNG ABFÄLLT

CIRCUIT FOR CONTROLLING EITHER THE CURRENT THROUGH AN ELECTRIC CONTROL DEVICE OR THE VOLTAGE ACROSS SAID ELECTRIC CONTROL DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.03.2010 FR 1052259**

(43) Date de publication de la demande:
**06.02.2013 Bulletin 2013/06**

(73) Titulaire: **Valeo Systèmes de Contrôle Moteur 95800 Cergy Saint-Christophe (FR)**

(72) Inventeurs:
• **DE SOUSA, Luis**
  **F-95670 Eragny Sur Oise (FR)**
• **GELEZ, Nicolas**
  **F- 78230 Le Pecq (FR)**
• **TALON, Emmanuel**
  **F-78480 Verneuil Sur Seine (FR)**

(56) Documents cités:
**EP-A1- 1 647 693      EP-A2- 1 420 468
US-A1- 2005 276 581**

**Description**

La présente invention concerne un circuit de contrôle du courant dans un organe électrique de commande ou de la tension aux bornes dudit organe électrique de commande. Une application particulièrement intéressante de l'invention se situe dans le domaine du contrôle du courant des machines électriques à inductance variable tels que les actionneurs utilisés pour les soupapes dites électromagnétiques (système « camless » en anglais) dans les véhicules automobiles.

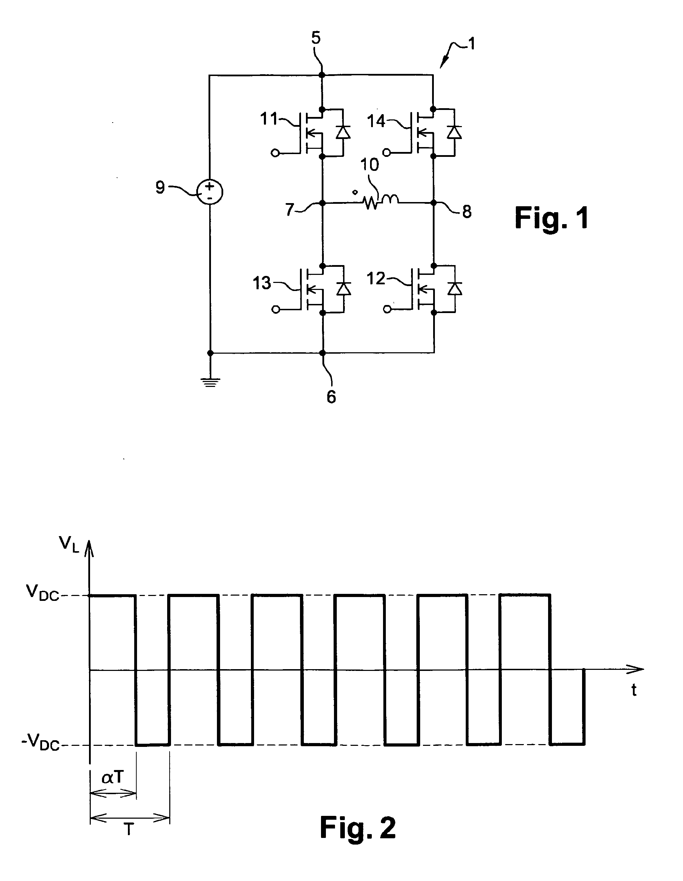

De façon générale, une machine électrique pilotée en courant positif ou négatif est souvent commandée par des ponts de puissance en H dits aussi ponts « quatre quadrants (ou « hacheur en pont complet ») monophasés ou polyphasés suivant la structure de la machine. On entend par pont « quatre quadrants », une commande de pont qui travaille sur tous les quadrants de la caractéristique tension-courant comme décrit par exemple dans le document US 2005/0276581 A1. Généralement, l'électronique de commande asservit le courant à une consigne en appliquant, aux ponts de puissance, une commande de type MLI (Modulation de Largeur d'Impulsion) à fréquence fixe. Un exemple de structure électronique d'un pont 1 « quatre quadrants » est représenté en figure 1. Le pont 1 comprend :

-   quatre bornes 5, 6, 7 et 8,
-   une source de tension continue 9, par exemple une batterie (il peut s'agir d'un convertisseur de puissance continu-continu DCDC ou d'un convertisseur de puissance alternatif continu ACDC) connectée aux première et deuxième bornes 5 et 6 du pont 1,
-   un organe électrique de commande 10 permettant de commander un actionneur et connecté entre les troisième et quatrième bornes 7 et 8 du circuit en pont 1,
-   un premier interrupteur 11 connecté entre les première et troisième bornes 5 et 7,
-   un deuxième interrupteur 14 connecté entre les première et quatrième bornes 5 et 8,
-   un troisième interrupteur 13 connecté entre les deuxième et troisième bornes 6 et 7,
-   un quatrième interrupteur 12 connecté entre les deuxième et quatrième bornes 6 et 8.

Les interrupteurs 11 à 14 de puissance peuvent être des transistors MOSFET (« Metal Oxide Semiconductor Field Effect Transistor » en anglais) ou des transistors IGBT (« Insulated Gate Bipolar Transistor » en anglais).

La technique la plus couramment utilisée pour sa robustesse est le contrôle du courant moyen. Son plus grand avantage est son immunité aux bruits. En effet, la boucle de régulation n'a pas besoin d'un courant instantané mais d'une valeur filtrée. Ce filtrage introduit un retard qui peut s'avérer très contraignant lorsqu'une grande bande passante est recherchée.

Dans le cas d'une commande d'actionneur de soupape électromagnétique, les temps de transition de l'état d'ouverture à l'état de fermeture ont besoin d'une grande précision et d'une grande répétitivité. Pour faire face à toutes les sources de bruit susceptibles de perturber la trajectoire de la soupape telles que les variations de pression dans les cylindres, les frottements ou les vibrations mécaniques, la génération du courant doit avoir une grande réactivité.

Il est nécessaire de garantir une grande bande passante sur toute la plage de l'organe électrique de charge. Cela est d'autant plus vrai lorsque cette charge possède une inductance fortement variable. La difficulté est de garantir une grande stabilité sur toute la plage tout en offrant la bande passante dont a besoin le système.

Garantir une bande passante minimum pour l'inductance maximale signifie que la bande passante est maximale pour l'inductance minimale. La conséquence est que le point dimensionnant est la stabilité à inductance minimale.

Par exemple, dans le cas d'un actionneur dont la réluctance (inversement proportionnelle à l'inductance) varie dans un rapport six, on observe généralement une bande passante qui varie dans les mêmes proportions. Si le système nécessite une bande passante minimale de 10Khz par exemple, alors la bande passante maximale sera de 60Khz alors que cette fréquence ne constitue pas un besoin. Il faut donc dimensionner un système stable ayant 60Khz de bande passante alors que le système ne nécessite que 10Khz de bande passante. En quelque sorte, le système est contraint à être surdimensionné. Assurer une stabilité robuste d'un système à haut produit gain-bande est très contraignant notamment dans le cas d'un contrôle de courant moyen. En effet, à de telles fréquences, plus aucun retard ne peut être négligé car ceux-ci peuvent rendre le système instable. En conséquence, l'ensemble des circuits électroniques utilisés dans la boucle de régulation devront avoir une bande passante importante avec une conséquence importante en termes de coût. En outre, la fréquence de découpage devra être au moins théoriquement deux fois supérieure à la bande passante maximale. En effet, le découpage réalisé par une modulation MLI introduit elle-même un déphasage pouvant rendre le système instable. Dans la pratique, les critères de stabilité conduisent à choisir une fréquence de découpage à une valeur bien supérieure à deux fois la bande passante maximale.

Une solution permettant de garantir une grande stabilité consiste à utiliser une commande à hystérésis utilisant des amplificateurs opérationnels à la place d'une commande du type MLI. Un exemple d'une telle commande est décrit dans la demande de brevet FR2876742. Un système à hystérésis est stable de manière intrinsèque : on a deux seuils (on commute en seuil haut ou bas). Il n'y a aucun retard lié à l'hystérésis dans la boucle et cela permet d'obtenir une bande passante élevée avec une bonne stabilité. Cette demande de brevet décrit cependant un pont qui ne permet pas de fonctionner en quatre quadrants dans la mesure seulement deux des interrupteurs sont commandés, les deux autres étant montés en diode.

La mise en oeuvre d'une commande comprenant un pont « quatre quadrants » pose un autre problème lié aux pertes par commutation. Dans une commande de pont « quatre quadrants » tel que celui représenté en figure 1, les interrupteurs 11 et 12 sont fermés pour magnétiser le circuit magnétique. Puis, après un temps mort empêchant que deux interrupteurs du même bras soient fermés simultanément, les interrupteurs 13 et 14 sont à leur tour fermés afin de démagnétiser le circuit magnétique. Lorsqu'un interrupteur change d'état (passage de ouvert à fermé ou passage de fermé à ouvert), il est le siège de pertes dues à la présence simultanée de courant le traversant et d'une tension à ses bornes. L'énergie alors dissipée dépend de la valeur du courant découpé, de la tension continue 9 et de la rapidité de la commutation (ces temps de commutation sont par exemple réglés par la valeur de la résistance de grille des transistors MOSFET). Ainsi, par période de découpage, il y a deux ouvertures et deux fermetures quel que soit le sens du courant sur un des deux interrupteurs de chacun des bras de pont. Cette double commutation par période de découpage entraîne bien entendu des pertes d'autant plus importantes que la fréquence sera élevée. On notera qu'il est important de concilier le rendement et la bande passante. Dans le cas d'une commande par MLI, la fréquence de la MLI est généralement de plusieurs centaines de kilohertz. A ces fréquences élevées les pertes par commutation sont prédominantes face aux autres pertes par conduction.

Une solution pour limiter ces pertes par commutation consiste à utiliser des techniques de commutation dite « douce ». On distingue celles qui sont passives et celles qui sont actives. Dans le premier cas, on ne sait pas assurer une commutation douce sur toute la plage de courant. Dans le deuxième cas, des interrupteurs de puissance supplémentaires et un circuit de commande plus complexe sont nécessaires.

Par ailleurs, les commutations répétées n'ont pas que des conséquences sur le rendement de l'électronique de commande mais également sur le rendement de la machine électrique qu'elles pilotent. Le découpage de la tension génère des harmoniques à haute fréquence qui induisent des pertes dans les machines électriques. Ces machines électriques sont généralement constituées de matériaux magnétiques propices aux courants de Foucault (Fer-Si par exemple). L'induction génère une tension induite dans les tôles qui, suivant leur résistivité, crée des courants de Foucault parfois importants. Bien que les tôles soient découpées finement et isolées entre elles, les courants qui y circulent génèrent des pertes par effet Joule. La figure 2 représente la tension $V_L$ aux bornes de la charge 10 telle que représentée en figure 1 avec une source de tension 9 présentant une valeur $V_{DC}$. La commande du pont est du type MLI avec un rapport cyclique $\alpha$. La tension $V_{DC}$, aux chutes de tension près dues aux résistances des interrupteurs, est appliquée à la charge 10. Quelque soit le rapport cyclique, si ce dernier est constant, la valeur efficace de la tension appliquée à la charge 10 est égale à la tension $V_{DC}$ (qui représente la tension crête de la tension $V_L$). Ainsi, les pertes générées par les courants de Foucault dont les fréquences sont au-delà de la fréquence de découpage, sont sensiblement proportionnelles à la tension crête.

En outre, une commande de pont génère des tensions de mode commun haute fréquence à cause du découpage. La charge présente généralement un couplage capacitif par rapport à la terre. Par exemple, dans le cas d'une machine électrique bobinée, il existe un couplage important entre le bobinage soumis à la tension de mode commun et la carcasse reliée à la terre. Des courants de mode commun sont ainsi générés et ils se bouclent par l'alimentation. Ces boucles de courant haute fréquence sont responsables du rayonnement électromagnétique susceptible d'avoir un impact en termes de respect des normes CEM (Comptabilité Electromagnétique) en vigueur.

De surcroit, lorsque la consigne de courant est nulle ou inférieure à la sensibilité en courant du système, les ponts de puissance continuent à découper à la même fréquence générant ainsi inutilement des pertes. Même pour un courant nul dans la charge, la puissance consommée pour commuter les interrupteurs à vide n'est pas négligeable : ceci est d'autant plus vrai pour des fréquences de découpage élevées. En effet, bien que les grilles de semi-conducteurs à effet de champ ne nécessitent pas de courant de polarisation, il faut néanmoins charger et décharger les charges accumulées dans la grille à travers une résistance de grille.

Une solution peut consister à déconnecter ces ponts. Dans le cas d'une commande d'actionneur polarisé, par exemple dans le cadre d'un système de soupapes électromagnétiques, la durée de l'activation des actionneurs est faible par rapport à la période d'utilisation. Toute la durée d'inactivité, il est intéressant de désactiver les ponts de puissance pour réduire la consommation à faible charge. Toutefois, ceci ne peut pas se faire de manière naturelle dans un contrôle de courant moyen à fréquence fixe. Il faut alors prévoir une commande supplémentaire qui soit capable de détecter la faible charge ou la consigne nulle et capable d'activer ou désactiver rapidement les ponts afin d'économiser les pertes même pendant de courtes durées. Cet ajout d'une commande présente bien entendu un surcoût important.

Dans ce contexte, la présente invention vise à fournir un circuit à pont « quatre quadrants » de contrôle du courant dans un organe électrique de commande ou de la tension aux bornes dudit organe de commande, ledit circuit permettant de façon économique de réduire les pertes par commutation dans les interrupteurs de puissance, de réduire les pertes liées aux courants de Foucault dans le circuit magnétique et de s'affranchir des problèmes de CEM précités.

A cette fin, l'invention propose un circuit de contrôle du courant dans un organe électrique de commande ou de la tension aux bornes dudit organe électrique de commande, ledit circuit comportant :

- un pont muni de quatre bornes et comportant quatre interrupteurs commandés,
- une source d'alimentation dudit pont,
- des moyens pour produire un signal de mesure représentatif du courant dans ledit organe électrique de commande ou de la tension aux bornes dudit organe électrique de commande,
- des moyens pour comparer ledit signal de mesure à un signal seuil haut,
- des moyens pour comparer ledit signal de mesure à un signal seuil bas,

ladite source d'alimentation étant connectée entre une première borne et une deuxième borne dudit pont, ledit organe électrique de commande étant connecté entre une troisième borne et quatrième borne dudit pont, le premier interrupteur étant connecté entre ladite première borne et ladite troisième borne dudit pont, le deuxième interrupteur étant connecté entre ladite première borne et ladite quatrième borne dudit pont, le troisième interrupteur étant connecté entre ladite troisième borne et ladite deuxième borne dudit pont, le quatrième interrupteur étant connecté entre ladite quatrième borne et ladite deuxième borne dudit pont, ledit circuit de contrôle étant caractérisé en ce qu'il comporte :

- des moyens de comptage pour détecter les événements suivants :

  o ledit signal de mesure atteint pour la deuxième fois le signal seuil haut,
  o ledit signal de mesure atteint pour la deuxième fois le signal seuil bas.

- des moyens de commande desdits interrupteurs, lesdits moyens de commande réagissant aux signaux de contrôle produits par :

  ○ lesdits moyens pour comparer ledit signal de mesure à un signal seuil haut,
  ○ lesdits moyens pour comparer ledit signal de mesure à un signal seuil bas,
  ○ lesdits moyens de comptage

lesdits moyens de commande autorisant au moins trois des quatre états suivants :

- un premier état dans lequel lesdits premier et quatrième interrupteurs sont fermés et lesdits deuxième et troisième interrupteurs sont ouverts,
- un deuxième état dans lequel lesdits deuxième et troisième interrupteurs sont fermés et lesdits premier et quatrième interrupteurs sont ouverts,
- au moins un des deux états suivants :

  ○ un troisième état dans lequel lesdits troisième et quatrième interrupteurs sont fermés et lesdits premier et deuxième interrupteurs sont ouverts,
  ○ un quatrième état dans lequel lesdits premier et deuxième interrupteurs sont fermés et lesdits troisième et quatrième interrupteurs sont ouverts.

Grâce à l'invention, le circuit de contrôle permet de gérer trois ou quatre états du pont « quatre quadrants » (i.e. le circuit permet de commuter sur trois ou quatre états différents). On utilise pour cela deux seuils (un signal seuil haut et un signal seuil bas) et un compteur. Un tel circuit permet de suivre une référence de courant ayant une forme d'onde indéterminée. Le changement d'état n'est pas prédéterminé à l'avance ; c'est la machine d'état programmé en fonction des signaux fournis par les comparateurs et le compteur qui permet de gérer les transitions d'état. Ainsi, le nombre de commutations d'interrupteurs et la fréquence de découpage sont optimisés et l'asservissement du courant est garanti.

Le système selon l'invention peut également présenter une ou plusieurs des caractéristiques ci-dessous, considérées individuellement ou selon toutes les combinaisons techniquement possibles.

Avantageusement, lesdits moyens de commande autorisent :

- la transition dudit premier état vers l'un au moins desdits troisième ou quatrième état,
- la transition dudit deuxième état vers l'un au moins desdits troisième ou quatrième état,
- la transition de l'un au moins desdits troisième ou quatrième état vers ledit premier état,
- la transition de l'un au moins desdits troisième ou quatrième état vers ledit deuxième état.

Avantageusement, lesdits moyens de commande autorisent lesdits quatre états, lesdits moyens de commande comportant des moyens pour mettre en oeuvre la machine d'état suivante :

- transition dudit premier état au dit quatrième état lorsque ledit signal de mesure est supérieur au dit signal seuil haut,
- transition dudit quatrième état au dit deuxième état lorsque ledit signal de mesure atteint deux fois ledit signal seuil haut,
- transition dudit deuxième état au dit troisième état lorsque ledit signal de mesure est inférieur au dit signal seuil bas,
- transition dudit troisième état au dit premier état lorsque ledit signal de mesure atteint deux fois ledit signal seuil bas,

- transition dudit quatrième état au dit premier état lorsque ledit signal de mesure est inférieur au dit signal seuil bas,
- transition dudit troisième état au dit deuxième état lorsque ledit signal de mesure est supérieur au dit signal seuil haut.

Selon un mode de réalisation préférentiel, le circuit de contrôle selon l'invention comporte en outre:

- des moyens pour comparer ledit signal de mesure à un signal seuil très haut supérieur au dit signal seuil haut,
- des moyens pour comparer ledit signal de mesure à un signal seuil très bas inférieur au dit signal seuil bas.

lesdits moyens de commande réagissant aux signaux de contrôle produits par lesdits moyens pour comparer ledit signal de mesure respectivement au dit signal seuil très haut et au dit signal seuil très bas.

Selon ce dernier mode de réalisation, préférentiellement, lesdits moyens de commande autorisent lesdits quatre états, lesdits moyens de commande comportant des moyens pour mettre en oeuvre la machine d'état suivante :

- transition dudit premier état au dit quatrième état lorsque ledit signal de mesure est supérieur au dit signal seuil haut,
- transition dudit quatrième état au dit deuxième état lorsque ledit signal de mesure atteint deux fois ledit signal seuil haut ou lorsque ledit signal de mesure est supérieur au dit signal seuil très haut,
- transition dudit deuxième état au dit troisième état lorsque ledit signal de mesure est inférieur au dit signal seuil bas,
- transition dudit troisième état au dit premier état lorsque ledit signal de mesure atteint deux fois ledit signal seuil bas ou lorsque ledit signal de mesure est inférieur au dit signal seuil très bas,
- transition dudit quatrième état au dit premier état lorsque ledit signal de mesure est inférieur au dit signal seuil bas,
- transition dudit troisième état au dit deuxième état lorsque ledit signal de mesure est supérieur au dit signal seuil haut.

De manière avantageuse :

- lesdits moyens pour comparer ledit signal de mesure à un autre signal sont formés par un comparateur à hystérésis.
- lesdits moyens de commande et/ou lesdits moyens de comptage sont inclus dans un circuit logique programmable.
- lesdits interrupteurs sont des transistors MOSFET.

La présente invention a également pour objet une utilisation du circuit de contrôle selon l'invention dans le cas d'un organe électrique formé par une charge inductive à inductance variable.

Avantageusement, l'organe électrique est compris dans un actionneur pourvu d'une pièce actionnée, ledit organe électrique commandant en déplacement ladite pièce actionnée.

Selon un mode de réalisation préférentiel, ledit actionneur est un actionneur de soupape électromagnétique d'un véhicule automobile.

D'autres caractéristiques et avantages de l'invention ressortiront clairement de la description qui en est donnée ci-dessous, à titre indicatif et nullement limitatif, en référence aux figures annexées, parmi lesquelles :

- la figure 1 est une représentation schématique simplifiée de la structure électronique d'un pont « quatre quadrants » illustrant l'état de la technique ;
- la figure 2 est une représentation de la tension $V_L$ aux bornes de la charge telle que représentée en figure 1 en fonction du temps ;
- la figure 3 est une représentation schématique simplifiée d'un circuit de contrôle selon l'invention ;
- la figure 4 à 7 illustrent les différents états du pont du circuit de contrôle selon l'invention ;
- la figure 8 représente de manière simplifiée un exemple de machine d'état mise en oeuvre dans le circuit de contrôle selon l'invention ;
- les figures 9 à 13 sont des exemples de régulation du courant de la charge par un circuit de contrôle selon l'invention ;
- la figure 14 représente trois courbes représentant la fréquence de découpage en fonction de la variation de la consigne ;
- la figure 15 illustre deux exemples de formes d'onde d'une commande selon l'art antérieur et d'une commande selon l'invention ;
- la figure 16 illustre la régulation du courant de la charge lorsque la consigne s'annule.

Dans toutes les figures, les éléments communs portent les mêmes numéros de référence.

Les figures 1 et 2 ont été décrites plus haut en référence à l'art antérieur.

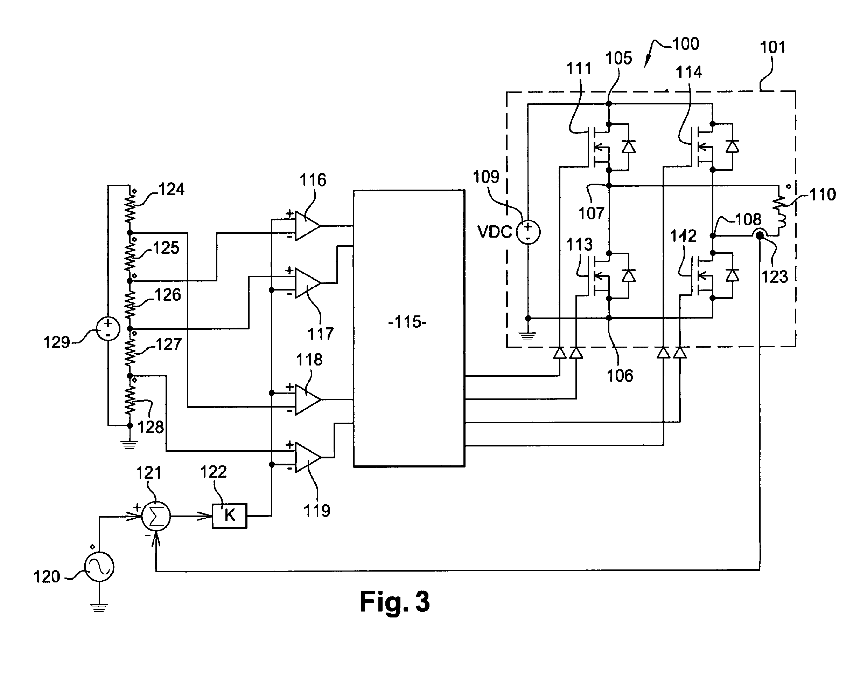

La figure 3 est une représentation schématique simplifiée d'un circuit de contrôle 100 selon l'invention.

Le circuit 100 comporte :

- un pont « quatre quadrants » 101,
- un circuit logique programmable FPGA (« Field Programmable Gate Array » en anglais) 115,
- un premier comparateur 116,
- un deuxième comparateur 117,
- un troisième comparateur 118,
- un quatrième comparateur 119,
- un capteur de courant 123,

- un soustracteur 121,
- une consigne de courant 120,
- une référence de tension 129 associée à quatre résistances fixes ou programmables 124 à 128.

Le pont en H « quatre quadrants » 101 comprend :

- quatre bornes 105, 106, 107 et 108,
- une source de tension continue 109 délivrant une tension $V_{DC}$, par exemple une batterie ou un convertisseur de puissance continu-continu DCDC (ou un convertisseur de puissance alternatif continu ACDC) connectée aux première et deuxième bornes 105 et 106 du pont 1,
- un organe électrique de commande 110 permettant de commander un actionneur et connecté entre les troisième et quatrième bornes 107 et 108,
- un premier interrupteur 111 connecté entre les première et troisième bornes 105 et 107,
- un deuxième interrupteur 114 connecté entre les première et quatrième bornes 105 et 108,
- un troisième interrupteur 113 connecté entre les deuxième et troisième bornes 106 et 107,
- un quatrième interrupteur 112 connecté entre les deuxième et quatrième bornes 106 et 108.

Les interrupteurs 111 à 114 de puissance sont par exemple des transistors MOSFET. Chaque transistor possède une diode montée en antiparallèle (présente par construction dans le cas des transistors MOSFET).

L'organe électrique de commande (appelé indifféremment charge par la suite) 110 est ici une inductance variable permettant de commander un actionneur (électroaimant) de soupapes électromagnétiques. L'inductance variable n'est bien entendu par parfaite et comporte une partie résistive. Le courant dans l'organe électrique de commande 110 permet de commander l'ouverture et la fermeture des soupapes (via des palettes qui maintiennent les soupapes en position ouverte ou fermée). La position des soupapes est définie par une consigne correspondant à un courant de consigne 120. Dès lors, le courant dans la charge 110 doit « suivre » le plus précisément le courant de consigne 120. Un tel suivi nécessite une boucle de rétroaction consistant à comparer le courant dans la charge 110 avec le courant de consigne 120.

Pour cela, le capteur de courant 123 (par exemple une résistance shunt) permet d"obtenir la valeur du courant dans l'organe électrique 110.

L'écart entre le courant de consigne 120 et le courant de charge est ensuite calculé par le soustracteur 121 puis amplifié par l'amplificateur 122. Cet écart correspond à un signal de mesure représentatif du courant dans la charge 110. Bien entendu, il est également tout à fait possible de mettre en oeuvre l'invention en utilisant directement le courant mesuré sans passer par une étape de calcul de l'écart : le calcul de l'écart offre davantage de précisions sur les étapes de comparaison qui seront décrites par la suite.

Les quatre comparateurs 116 à 119 fonctionnent chacun en comparateur à hystérésis et permettent de comparer un signal de mesure (tension proportionnelle à l'écart ou tension proportionnelle au courant mesuré) à différentes valeurs de seuil.

Le premier comparateur 116 permet de comparer la valeur de courant dans la charge 110 à une valeur de seuil haut de la consigne.

Le deuxième comparateur 117 permet de comparer la valeur du courant dans la charge 110 à une valeur de seuil bas de la consigne.

Le troisième comparateur 118 permet de comparer la valeur de courant de la charge 110 à une valeur de seuil très bas inférieure à la valeur de seuil bas mentionnée ci-dessus : cette valeur sera dénommée par la suite garde-fou inférieur.

Le quatrième comparateur 119 permet de comparer la valeur de courant de la charge 110 à une valeur de seuil très haut supérieure à la valeur de seuil haut mentionnée ci-dessus : cette valeur sera dénommée par la suite garde-fou supérieur.

Les signaux de seuil haut et bas ainsi que les signaux de garde-fou forment une fenêtre (i.e. un gabarit) de régulation encadrant la consigne 120 et le courant de charge 110 ne doit pas sortir de cette fenêtre.

On notera que les seuils haut et bas (dits indifféremment seuil supérieur et seuil inférieur par la suite) de consigne ainsi que les garde-fous supérieur et inférieur sont générés par une même référence de tension 129, les seuils et garde-fous étant fixés par des résistances 124 à 128 formant des ponts diviseur de tension.

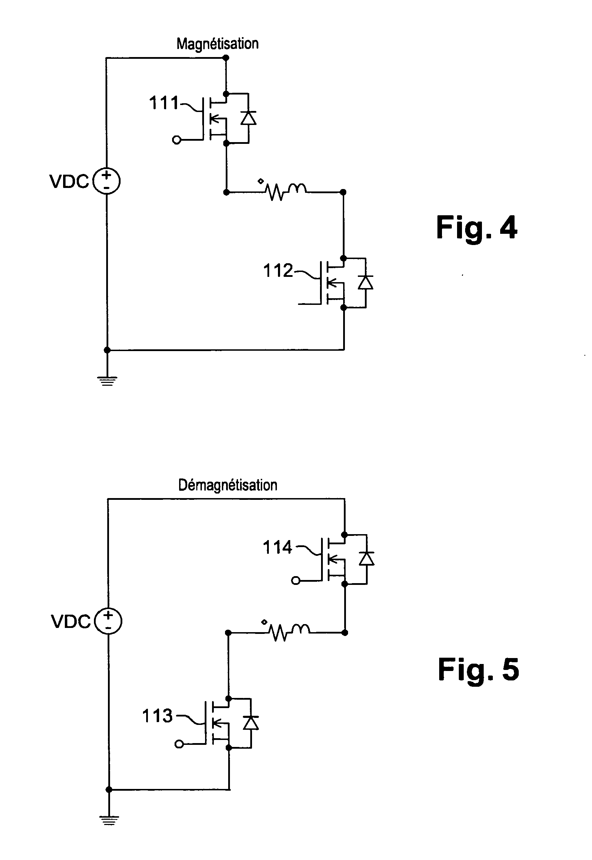

Comme nous allons le détailler par la suite, le pont 101 peut être utilisé selon quatre états différents : ces quatre états sont illustrés sur les figures 4 à 7.

Dans les commandes classiques des ponts « quatre quadrants », seuls les états représentés sur les figures 4 et 5 sont utilisés :

- un premier état de magnétisation représenté en figure 4 dans lequel les premier et quatrième interrupteurs 111 et 112 sont fermés et les deuxième et troisième interrupteurs sont ouverts (non représentés),
- un deuxième état de démagnétisation dans lequel les deuxième et troisième interrupteurs 114 et 113 sont fermés et les premier et quatrième interrupteurs sont ouverts (non représentés).

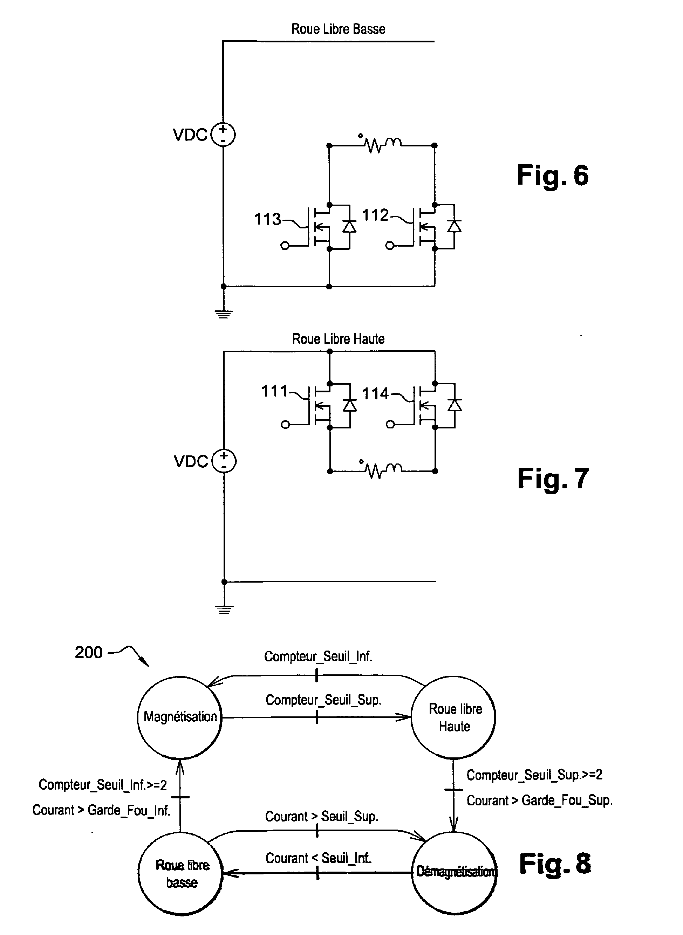

Selon l'invention, au moins un des deux états représentés sur les figures 6 et 7 est également employé:

- un troisième état dit de « roue libre basse » dans lequel les troisième et quatrième interrupteurs 113 et 112 sont fermés et les premier et deuxième interrupteurs sont ouverts (non représentés),
- un quatrième état dit de « roue libre haute » dans lequel les premier et deuxième interrupteurs 111 et 114 sont fermés et les troisième et quatrième interrupteurs sont ouverts (non représentés).

Comme nous allons le voir par la suite, l'intérêt de l'introduction de ces trois ou quatre états est qu'ils permettent de réduire le nombre de commutation par période. Le passage de l'état de magnétisation à l'état de démagnétisation et inversement nécessite deux commutations alors qu'une transition de l'état de magnétisation ou de l'état de démagnétisation à un état de roue libre (haute ou basse) nécessite une seule commutation. En effet, dans le premier cas, les deux bras commutent simultanément alors que dans l'autre cas un seul bras commute.

Les résultats des comparaisons effectuées par les comparateurs 116 à 119 sont fournis au FPGA 115 qui pilote les interrupteurs 111 à 114 du pont 101.

Le FPGA comporte des moyens de comptage pour détecter les événements suivants :

○ le courant atteint pour la deuxième fois le signal seuil haut,
○ le courant atteint pour la deuxième fois le signal seuil bas.

Le FPGA comporte en outre des moyens pour mettre en oeuvre la machine d'état 200 simplifiée telle que représentée en figure 8. Cette machine d'état 200 détecte quatre événements :

- le dépassement du seuil supérieur par le bas détecté via le comparateur 116,
- le dépassement du seuil inférieur par le haut détecté via le comparateur 117,
- deux dépassements consécutifs du seuil supérieur par le bas détectés via les moyens de comptage ou le dépassement du garde-fou supérieur par le bas détecté via le comparateur 119,
- deux dépassements consécutifs du seuil inférieur par le haut détectés via les moyens de comptage ou le dépassement du garde-fou inférieur par le haut détecté via le comparateur 118.

La machine d'état 200 maintient le courant de charge dans la fenêtre de régulation. Si le courant sort de cette fenêtre, un état commandé adéquat ramène le courant dans la fenêtre de régulation. La détection est réalisée par comparaison de la mesure et des seuils (supérieur ou inférieur) et des garde-fous qui délimitent la fenêtre de régulation.

Afin d'économiser le nombre de commutation, il n'y a jamais de transition directe entre l'état de magnétisation et l'état de démagnétisation.

Les transitions se définissent comme suit :

- transition de l'état de magnétisation à l'état de roue libre haute lorsque le courant passe au-dessus du seuil haut,
- transition de l'état de roue libre haute à l'état de démagnétisation lorsque le courant passe deux fois au-dessus du seuil haut ou lorsque le courant passe au-dessus du garde-fou supérieur,
- transition de l'état de démagnétisation à l'état de roue libre basse lorsque le courant passe au-dessous du seuil bas,
- transition de l'état de roue libre basse à l'état de magnétisation lorsque le courant passe deux fois au-dessous du seuil bas ou lorsque le courant passe au-dessous du garde-fou inférieur,
- transition de l'état de roue libre haute à l'état de magnétisation lorsque le courant passe au-dessous du seuil bas,
- transition de l'état de roue libre basse à l'état de démagnétisation lorsque le courant passe au-dessus du seuil haut.

On notera que la machine d'état utilise les deux états de roue libre basse et haute ; ces deux états (roue libre haute et basse) remplissent la même fonction et il est également possible de n'utiliser qu'un seul des deux états de roue libre.

Afin d'économiser le nombre de commutations, il n'y a jamais de transition directe entre l'état de magnétisation et l'état de démagnétisation. Ainsi, pour une fréquence donnée, il est possible de réduire le nombre de commutation par deux. En outre, le contrôle par hystérésis permet de réduire la fréquence en moyenne. Le contrôle par hystérésis permet le changement d'état de manière automatique et permet la génération d'une fréquence de découpage qui s'adapte naturellement aux variations de la consigne.

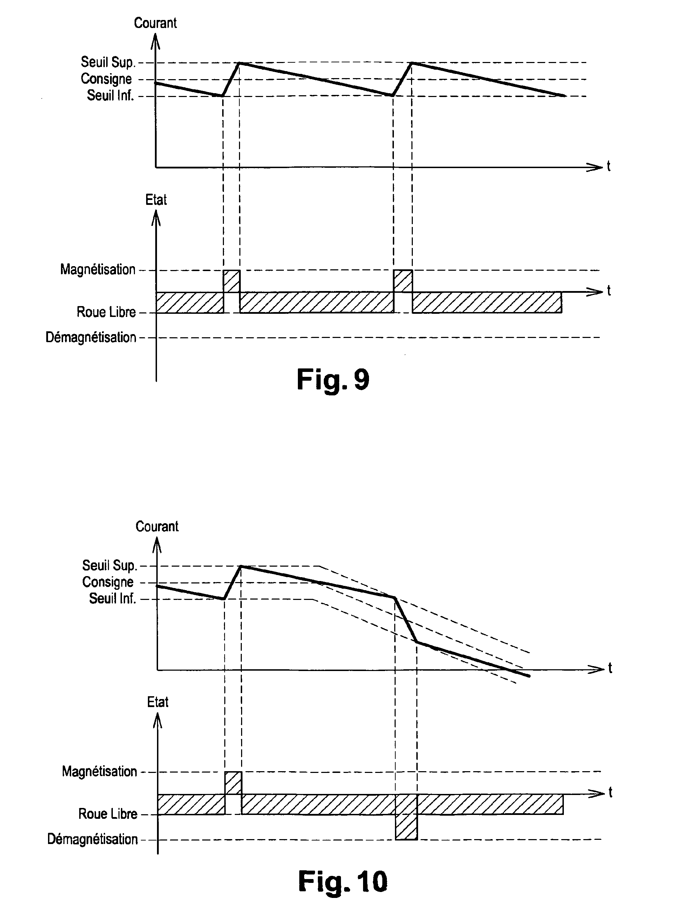

La figure 9 illustre le cas d'un courant positif dans la charge 110 en fonction du temps. La figure 9 représente le cas d'une consigne constante encadrée par deux valeurs de seuil supérieur et inférieur ; les états correspondants sont représentés en dessous de la courbe courant-temps. Quand la mesure du courant dans la charge 110 atteint le seuil haut, le pont commute sur l'état de roue libre haute ou basse (roue libre haute dans le cas de la machine d'état décrite plus haut). Le courant revient alors dans la fenêtre de régulation. La décroissance du courant dans l'état de roue libre est plus lente (c'est une décharge lente) car le flux de démagnétisation est faible ; cette décroissance correspond à une démagnétisation du matériau magnétique dans les résistances de bobinage.
Lorsque le courant atteint le seuil bas, le pont commute de nouveau sur l'état de magnétisation. A chaque transition, une seule commutation a lieu.

Le cas d'une décroissance de la consigne est illustré par la figure 10. Lorsque la consigne de courant décroît plus vite que le courant en roue libre, le courant atteint le seuil haut deux fois consécutivement. Ceci est détecté par les moyens de comptage de la machine d'état 200 mise en oeuvre par le FPGA 115 qui commute le pont sur l'état de démagnétisation. La décroissance de courant est plus importante que celle observée en roue libre. Lorsque le courant atteint le seuil inférieur, le pont commute en roue libre.

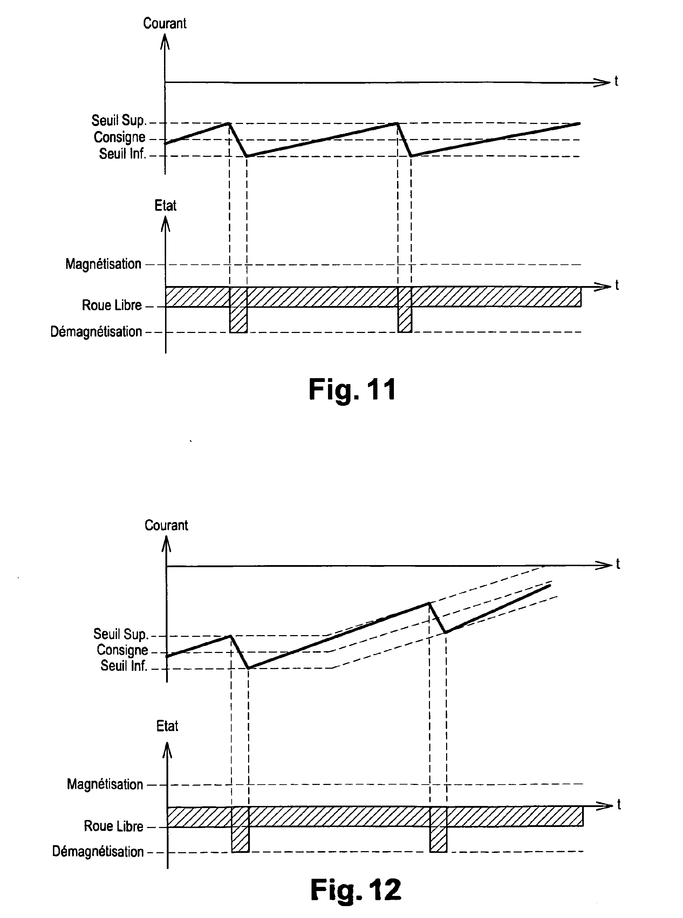

Les cas complémentaires du courant négatif sans ou avec croissance de la consigne sont illustrés respectivement par les figures 11 et 12.

Ainsi, selon les figures 11 et 12, quand la mesure du courant dans la charge 110 atteint le seuil bas, le pont commute sur l'état de roue libre haute ou basse (roue libre basse dans le cas de la machine d'état décrite plus haut). Le courant revient alors dans la fenêtre de régulation. La croissance du courant dans l'état de roue libre est plus lente (c'est une charge lente). Lorsque le courant atteint le seuil haut, le pont commute de nouveau sur l'état de magnétisation. A nouveau, à chaque transition, une seule commutation a lieu.

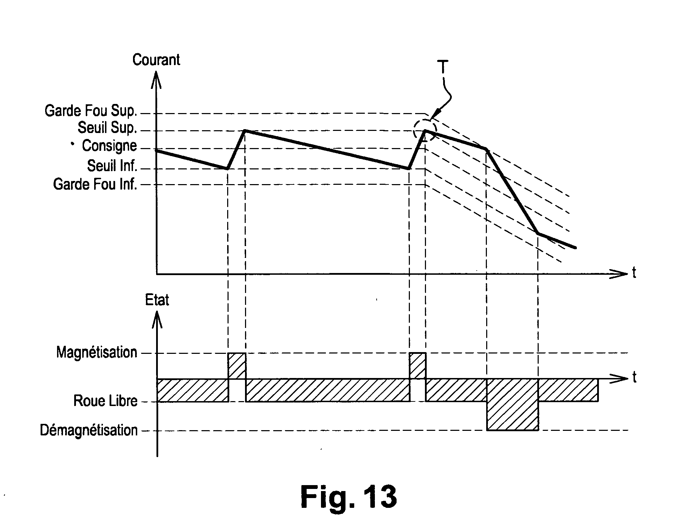

Les garde-fous supérieur et inférieur sont utilisés pour palier à une absence de transition pourtant nécessaire d'un mode de roue libre vers un état de magnétisation ou de démagnétisation. Ces garde-fous garantissent que le courant reste dans la fenêtre de régulation tant que la tension ou la charge restent dans leurs plages nominales. Dans certains cas, la machine d'état pourrait rester dans un mode de roue libre alors qu'elle devrait commuter en démagnétisation ou magnétisation. L'exemple de la figure 13 illustre cette situation. Ainsi, cette situation peut se produire dans le cas où le changement d'état T (passage d'un état de magnétisation à un état de roue libre haute lié au franchissement du seuil supérieur) se produit exactement au moment où la consigne se met à décroitre plus rapidement que le courant. Dans ce cas, le passage au-dessus du garde-fou supérieur permet de basculer de l'état de roue libre haute à un état de démagnétisation de manière à faire revenir le courant dans la fenêtre de régulation. En d'autres termes, les garde-fous ne sont utiles que pour palier à l'utilisation inefficace des seuils supérieur ou inférieur dans des circonstances particulières.

Grâce à l'utilisation de comparateurs à hystérésis, le circuit de contrôle selon l'invention ne comporte pas de problème d'instabilité lié à des retards dans la boucle de régulation. Des composants standards peuvent être utilisés. Une grande bande passante et la robustesse de la stabilité ne sont plus incompatibles.

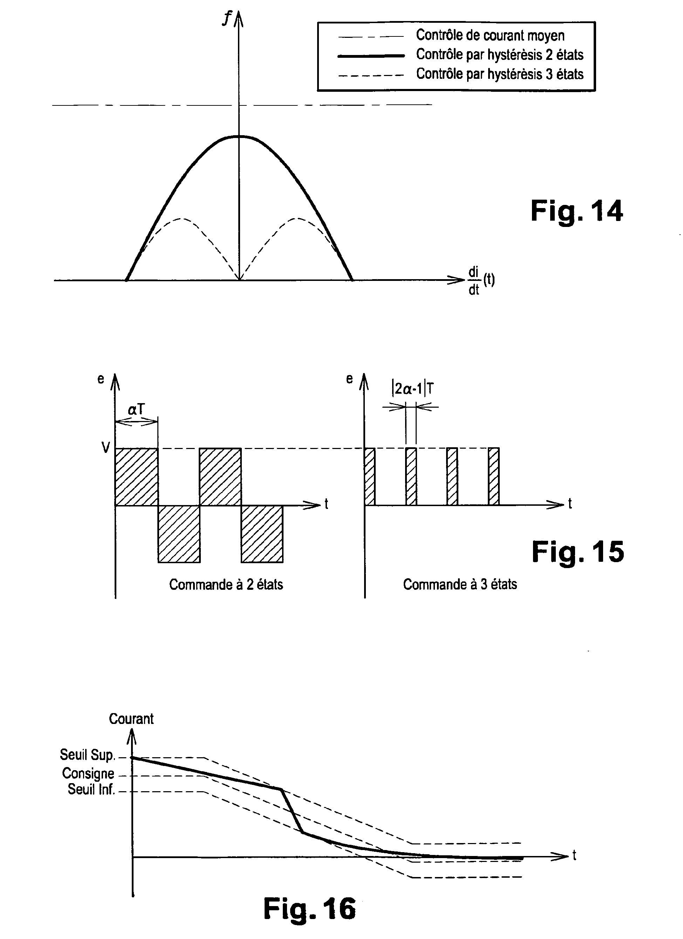

Comme évoqué plus haut, l'un des intérêts du circuit selon l'invention est donc de diviser par un facteur deux au minimum le nombre de commutations et également de diminuer la fréquence de découpage quand cela est possible. La figure 14 illustre la dépendance de la fréquence à la variation de consigne dans le cas d'un contrôle de type MLI (courant moyen), d'un contrôle par hystérésis à deux états et d'un contrôle selon l'invention. La fréquence de découpage du circuit de contrôle selon l'invention est bien entendu très largement réduite par rapport à une fréquence MLI et sensiblement réduite par rapport à une méthode de contrôle par hystérésis conventionnelle.

Concernant les pertes par courant de Foucault, la valeur efficace est très différente entre une commande conventionnelle de pont quatre quadrants qui commute le pont sur deux états et la commande proposée selon l'invention qui commute le pont entre trois ou quatre états. La commande à trois ou quatre états applique moins de tension pour contrôler le même courant c'est-à-dire pour fournir la même tension moyenne. La figure 15 illustre les formes d'onde d'une commande à deux états et d'une commande à trois états selon l'invention. Sur cette figure, les deux ondes ont la même valeur moyenne mais des valeurs efficaces très différentes. Dans le cas d'une onde d'une commande trois états, les pertes par courant de Foucault sont réduites d'un facteur $\sqrt{2|\alpha - 1|}$ avec $\alpha$ représentant le rapport cyclique compris entre 0 et 1.

Par ailleurs, lorsque la consigne s'annule et reste nulle suffisamment longtemps, la décroissance de la consigne implique que la machine d'état transite par un état de roue libre. La roue libre consiste en la démagnétisation du matériau magnétique dans les résistances du bobinage. Si la consigne reste nulle suffisamment longtemps alors la démagnétisation sera complète et le courant restera nul car le courant restera naturellement dans la fenêtre de régulation. Il n'y a pas de dépassement. Dans ce cas, le pont ne commute pas et les pertes dans la commande sont économisées. Cette situation est illustrée par la figure 16.

En outre, un pont de puissance conventionnel qui est activé en permanence ne permet pas de garantir l'asservissement d'un courant nul. Le courant résiduel dépendra de la précision de mesure. L'écart peut être corrigé par calibration. Cependant, la déviation demeure à cause des variations de température et du vieillissement. L'auto compensation n'est pas possible. Dans le cas de l'invention, comme nous l'avons expliqué plus haut, le courant s'annule naturellement lorsque la consigne est nulle. Il n'y a pas de courant résiduel. Lorsque la consigne est commandée à zéro, après un certain délai, le système est informé de manière certaine que le courant est nul. Donc la mesure de courant devrait être nulle. Toutefois, la mesure n'est généralement jamais nulle car la chaîne de mesure accumule toutes les erreurs absolues (« offset ») apportées par les amplificateurs opérationnels, par décalage de référence, par les courants de polarisation des amplificateurs. La mesure à zéro de courant donne l'erreur absolue et celle-ci peut être retranchée de la mesure en temps réel par le logiciel. Finalement, cette méthode permet de réaliser une auto-calibration en continue sur toute la vie du produit. Elle permet donc de compenser les erreurs absolues même en fonction de la température.

Un système basé sur l'asservissement d'une grandeur physique issue d'une machine électrique pilotée par une électronique de commande à découpage, peut rencontrer des difficultés de compatibilité électromagnétique entre un perturbateur, la commande qui commute des courants forts à la vitesse de plusieurs centaines d'ampère par microseconde, et un récepteur victime, le capteur qui est sensible à quelques centaines de microvolts.

C'est le cas par exemple, d'une machine électrique asservie en position. La commutation du courant par le pont « quatre quadrants » induit par conduction et rayonnement une perturbation sur les signaux de mesure. La régulation de la position peut être pénalisée par ce bruit.

Une solution consiste à réaliser les acquisitions de position pendant une période dite de « temps mort silencieux » pendant laquelle il est garanti qu'aucune commutation n'aura lieu. Cette période de temps mort est déclenchée par l'envoi d'un signal d'autorisation d'acquisition (« enable » en anglais) pendant lequel aucune commutation ne doit avoir lieu. Ceci est rendu possible par le fait que la mesure est échantillonnée par les convertisseurs analogiques numériques et par la synchronisation entre la fréquence de découpage et la fréquence d'échantillonnage.

Le circuit selon l'invention est particulièrement bien adapté à la mise en oeuvre de ces temps morts silencieux puisque la stabilité de la commande proposée n'est pas pénalisée par des retards ; il est alors possible de retarder le changement d'état du pont lorsqu'un signal d'autorisation est envoyé par le système d'acquisition. L'acquisition peut être réalisée pendant une période de silence. La commutation est réalisée une fois que le signal d'autorisation est relâché. Le dépassement est généralement négligeable pour la valeur de l'inductance de la charge.

On notera enfin que le circuit selon l'invention avec une commande par hystérésis à 3 états génère moins d'harmonique à haute fréquence. Le spectre de bruit est donc étalé et le bruit de mode commun ainsi généré sera beaucoup moins important.

Bien entendu, l'invention n'est pas limitée au mode de réalisation qui vient d'être décrit.

Notamment, l'invention a été décrite dans le cas d'une application à un actionneur de soupapes électromagnétiques mais elle s'applique à tout type de machine électrique commandée par une charge inductive telle qu'un moteur électrique par exemple.

Dans le cas d'une application à une machine électrique, cette dernière peut être mono ou triphasée.

En outre, le mode de réalisation décrit concerne le contrôle du courant dans une charge inductive mais l'invention s'applique bien entendu au contrôle de la tension aux bornes de cette même charge.

Par ailleurs, nous avons décrit une application dans laquelle un FPGA est programmé de façon à mettre en oeuvre une machine d'état ; il est également possible de mettre en oeuvre cette machine d'état en utilisant une logique câblée.

On notera que l'invention a été plus particulièrement décrite dans le cas d'une utilisation de transistors MOSFET ; d'autres types de transistors (IGBT par exemple) peuvent également être utilisés sans sortir du cadre de l'invention.

Enfin, on pourra remplacer tout moyen par un moyen équivalent.

## Revendications

**1.** Circuit (100) de contrôle du courant dans un organe électrique (110) de commande ou de la tension aux bornes dudit organe électrique (110) de commande, ledit circuit (100) comportant :

    - un pont (101) muni de quatre bornes (105, 106, 107, 108) et comportant quatre interrupteurs commandés (111, 112, 113, 114),
    - une source d'alimentation dudit pont (109),
    - des moyens (123) pour produire un signal de mesure représentatif du courant dans ledit organe électrique (110) de commande ou de la tension aux bornes dudit organe électrique (110) de commande,
    - des moyens (116) pour comparer ledit signal de mesure à un signal seuil haut,
    - des moyens (117) pour comparer ledit signal de mesure à un signal seuil bas,

ladite source d'alimentation (109) étant connectée entre une première borne (105) et une deuxième borne (106) dudit pont (101),
ledit organe électrique (110) de commande étant connecté entre une troisième borne (107) et quatrième borne (108) dudit pont (101),
le premier interrupteur (111) étant connecté entre ladite première borne (105) et ladite troisième borne (107) dudit pont (101),
le deuxième interrupteur (114) étant connecté entre ladite première borne (105) et ladite quatrième borne (108) dudit pont (101),
le troisième interrupteur (113) étant connecté entre ladite troisième borne (106) et ladite deuxième borne (107) dudit pont (101),
le quatrième interrupteur (112) étant connecté entre ladite quatrième borne (106) et ladite deuxième borne (108) dudit pont (101),
ledit circuit de contrôle (100) étant **caractérisé en ce qu'**il comporte :

    - des moyens (115) de comptage pour détecter les événements suivants :

        o ledit signal de mesure atteint pour la deuxième fois le signal seuil haut,
        ○ ledit signal de mesure atteint pour la deuxième fois le signal seuil bas.

    - des moyens (115) de commande desdits interrupteurs, lesdits moyens de commande réagissant aux signaux de contrôle produits par :

    ○ lesdits moyens (116) pour comparer ledit signal de mesure à un signal seuil haut,
    ○ lesdits moyens (117) pour comparer ledit signal de mesure à un signal seuil bas,
    ○ lesdits moyens (115) de comptage

lesdits moyens (115) de commande autorisant au moins trois des quatre états suivants :

    - un premier état dans lequel lesdits premier (111) et quatrième (112) interrupteurs sont fermés et lesdits deuxième (114) et troisième (113) interrupteurs sont ouverts,
    - un deuxième état dans lequel lesdits deuxième (114) et troisième (113) interrupteurs sont fermés et lesdits premier (111) et quatrième (112) interrupteurs sont ouverts,
    - au moins un des deux états suivants :

        ○ un troisième état dans lequel lesdits troisième (113) et quatrième (112) interrupteurs sont fermés et lesdits premier (111) et deuxième (114) interrupteurs sont ouverts,
        ○ un quatrième état dans lequel lesdits premier (111) et deuxième (114) interrupteurs sont fermés et lesdits troisième (113) et quatrième (112) interrupteurs sont ouverts.

**2.** Circuit (100) de contrôle selon la revendication précédente **caractérisé en ce que** lesdits moyens (115) de commande autorisent :

    - la transition dudit premier état vers l'un au moins desdits troisième ou quatrième état,
    - la transition dudit deuxième état vers l'un au moins desdits troisième ou quatrième état,
    - la transition de l'un au moins desdits troisième ou quatrième état vers ledit premier état,
    - la transition de l'un au moins desdits troisième ou quatrième état vers ledit deuxième état.

**3.** Circuit (100) de contrôle selon l'une des revendications précédentes **caractérisé en ce que** lesdits moyens (115) de commande autorisent lesdits quatre états, lesdits moyens de commande comportant des moyens pour mettre en oeuvre la machine d'état (200) suivante :

    - transition dudit premier état au dit quatrième état lorsque ledit signal de mesure est supérieur au dit signal seuil haut,
    - transition dudit quatrième état au dit deuxième état lorsque ledit signal de mesure atteint deux fois ledit signal seuil haut,
    - transition dudit deuxième état au dit troisième état lorsque ledit signal de mesure est inférieur au dit signal seuil bas,
    - transition dudit troisième état au dit premier état lorsque ledit signal de mesure atteint deux fois ledit signal seuil bas,
    - transition dudit quatrième état au dit premier état lorsque ledit signal de mesure est inférieur au dit signal seuil bas,
    - transition dudit troisième état au dit deuxième état lorsque ledit signal de mesure est supérieur au dit signal seuil haut.

**4.** Circuit (100) de contrôle selon l'une des revendications précédentes **caractérisé en ce qu'**il comporte :

    - des moyens (119) pour comparer ledit signal de mesure à un signal seuil très haut supérieur au dit signal seuil haut,
    - des moyens (118) pour comparer ledit signal de mesure à un signal seuil très bas inférieur au dit signal seuil bas.
    lesdits moyens (115) de commande réagissant aux signaux de contrôle produits par lesdits moyens (118, 119) pour comparer ledit signal de mesure respectivement au dit signal seuil très haut et au dit signal seuil très bas.

**5.** Circuit (100) de contrôle selon la revendication précédente **caractérisé en ce que** lesdits moyens de commande autorisent lesdits quatre états, lesdits moyens de commande comportant des moyens pour mettre en oeuvre la machine d'état (200) suivante :

    - transition dudit premier état au dit quatrième état lorsque ledit signal de mesure est supérieur au dit signal seuil haut,
    - transition dudit quatrième état au dit deuxième état lorsque ledit signal de mesure atteint deux fois ledit signal seuil haut ou lorsque ledit signal de mesure est supérieur au dit signal seuil très haut,
    - transition dudit deuxième état au dit troisième état lorsque ledit signal de mesure est inférieur au dit signal seuil bas,
    - transition dudit troisième état au dit premier état lorsque ledit signal de mesure atteint deux fois ledit signal seuil bas ou lorsque ledit signal de mesure est inférieur au dit signal seuil très bas,
    - transition dudit quatrième état au dit premier état lorsque ledit signal de mesure est inférieur au dit signal seuil bas,
    - transition dudit troisième état au dit deuxième état lorsque ledit signal de mesure est supérieur au dit signal seuil haut.

**6.** Circuit (100) de contrôle selon l'une des revendications précédentes **caractérisé en ce que** lesdits moyens pour comparer ledit signal de mesure à un autre signal sont formés par un comparateur à hystérésis (116, 117, 118, 119).

7.  Circuit (100) de contrôle selon l'une des revendications précédentes **caractérisé en ce que** lesdits moyens de commande et/ou lesdits moyens de comptage sont inclus dans un circuit logique programmable (115).

8.  Circuit (100) de contrôle selon l'une des revendications précédentes **caractérisé en ce que** lesdits interrupteurs sont des transistors MOSFET (111, 112, 113, 114).

9.  Utilisation du circuit de contrôle selon l'une des revendications précédentes pour un organe électrique formé par une charge inductive à inductance variable.

10. Utilisation selon la revendication précédente **caractérisée en ce que** l'organe électrique est compris dans un actionneur pourvu d'une pièce actionnée, ledit organe électrique commandant en déplacement ladite pièce actionnée.

11. Utilisation selon la revendication précédente **caractérisée en ce que** ledit actionneur est un actionneur de soupape électromagnétique d'un véhicule automobile.


**Patentansprüche**

1.  Schaltung (100) zum Steuern des Stroms in einem elektrischen Steuerorgan (110) oder der Spannung an den Anschlüssen des elektrischen Steuerorgans (110), wobei die Schaltung (100) Folgendes umfasst:

    - eine Brücke (101), die mit vier Anschlüssen (105, 106, 107, 108) versehen ist und vier gesteuerte Ein/Aus-Schalter (111, 112, 113, 114) enthält,
    - eine Versorgungsquelle der Brücke (109),
    - Mittel (123) zum Erzeugen eines Messsignals, das den Strom in das elektrische Steuerorgan (110) oder die Spannung an den Anschlüssen des elektrischen Steuerorgans (110) repräsentiert,
    - Mittel (116) zum Vergleichen des Messsignals mit einem oberen Schwellensignal,
    - Mittel (117) zum Vergleichen des Messsignals mit einem unteren Schwellensignal,

    wobei die Versorgungsquelle (109) zwischen einen ersten Anschluss (105) und einen zweiten Anschluss (106) der Brücke (101) geschaltet ist, wobei das elektrische Steuerorgan (110) zwischen einen dritten Anschluss (107) und einen vierten Anschluss (108) der Brücke (101) geschaltet ist, wobei der erste Ein/Aus-Schalter (111) zwischen den ersten Anschluss (105) und den dritten Anschluss (107) der Brücke (101) geschaltet ist, wobei der zweite Ein/Aus-Schalter (114) zwischen den ersten Anschluss (105) und den vierten Anschluss (108) der Brücke (101) geschaltet ist, wobei der dritte Ein/Aus-Schalter (113) zwischen den dritten Anschluss (106) und den zweiten Anschluss (107) der Brücke (101) geschaltet ist, wobei der vierte Ein/Aus-Schalter (112) zwischen den vierten Anschluss (106) und den zweiten Anschluss (108) der Brücke (101) geschaltet ist, wobei die Steuerschaltung (100) **dadurch gekennzeichnet ist, dass** sie Folgendes umfasst:

- Zählmittel (115), um die folgenden Ereignisse zu detektieren:

    o das Messsignal erreicht zum zweiten Mal das obere Schwellensignal,
    o das Messsignal erreicht zum zweiten Mal das untere Schwellensignal,

- Mittel (115) zum Steuern der Ein/Aus-Schalter, wobei die Steuermittel auf die Steuersignale reagieren, die erzeugt werden durch:

    o die Mittel (116), um das Messsignal mit einem oberen Schwellensignal zu vergleichen,
    o die Mittel (117) zum Vergleichen des Messsignals mit einem unteren Schwellensignal,
    o die Zählmittel (115),

wobei die Steuermittel (115) wenigstens drei der folgenden Zustände zulassen:

- einen ersten Zustand, in dem der erste (111) und der vierte (112) Ein/Aus-Schalter geschlossen sind und der zweite (114) und der dritte (113) Ein/AusSchalter geöffnet sind,
- einen zweiten Zustand, in dem der zweite (114) und der dritte (113) Ein/Aus-Schalter geschlossen sind und der erste (111) und der vierte (112) Ein/AusSchalter geöffnet sind,
- wenigstens einen der zwei folgenden Zustände:

    o einen dritten Zustand, in dem der dritte (113) und der vierte (112) Ein/Aus-Schalter geschlossen sind und der erste (111) und der zweite (114) Ein/Aus-Schalter geöffnet sind,

o einen vierten Zustand, in dem der erste (111) und der zweite (114) Ein/Aus-Schalter geschlossen sind und der dritte (113) und der vierte (112) Ein/Aus-Schalter geöffnet sind.

2. Steuerschaltung (100) nach dem vorhergehenden Anspruch, **dadurch gekennzeichnet, dass** die Steuermittel (115) Folgendes zulassen:

- den Übergang von dem ersten Zustand in wenigstens einen des dritten und des vierten Zustands,
- den Übergang von dem zweiten Zustand in wenigstens einen des dritten und des vierten Zustands,
- den Übergang von wenigstens einem des dritten und des vierten Zustands in den ersten Zustand,
- den Übergang von wenigstens einem des dritten und des vierten Zustands in den zweiten Zustand.

3. Steuerschaltung (100) nach einem der vorhergehenden Ansprüche, **dadurch gekennzeichnet, dass** die Steuermittel (115) die vier Zustände zulassen, wobei die Steuermittel Mittel umfassen, um die folgende Zustandsmaschine (200) auszuführen:

- Übergang vom ersten Zustand in den vierten Zustand, wenn das Messsignal größer als das obere Schwellensignal ist,
- Übergang vom vierten Zustand in den zweiten Zustand, wenn das Messsignal das obere Schwellensignal zweimal erreicht,
- Übergang vom zweiten Zustand in den dritten Zustand, wenn das Messsignal kleiner als das untere Schwellensignal ist,
- Übergang vom dritten Zustand in den ersten Zustand, wenn das Messsignal das untere Schwellensignal zweimal erreicht,
- Übergang vom vierten Zustand in den ersten Zustand, wenn das Messsignal kleiner ist als das untere Schwellensignal,
- Übergang vom dritten Zustand in den zweiten Zustand, wenn das Messsignal größer ist als das obere Schwellensignal.

4. Steuerschaltung (100) nach einem der vorhergehenden Ansprüche, **dadurch gekennzeichnet, dass** es Folgendes umfasst:

- Mittel (119) zum Vergleichen des Messsignals mit einem sehr hohen Schwellensignal, das größer ist als das obere Schwellensignal,
- Mittel (118) zum Vergleichen des Messsignals mit einem sehr niedrigen Schwellensignal, das niedriger ist als das untere Schwellensignal,

wobei die Steuermittel (115) auf die Steuersignale, die von den Mitteln (118, 119) zum Vergleichen des Messsignals mit dem sehr hohen Schwellensignal bzw. mit dem sehr niedrigen Schwellensignal erzeugt werden, reagieren.

5. Steuerschaltung (100) nach dem vorhergehenden Anspruch, **dadurch gekennzeichnet, dass** die Steuermittel die vier Zustände zulassen, wobei die Steuermittel Mittel umfassen, um die folgende Zustandsmaschine (200) auszuführen:

- Übergang vom ersten Zustand in den vierten Zustand, wenn das Messsignal größer ist als das obere Schwellensignal,
- Übergang vom vierten Zustand in den zweiten Zustand, wenn das Messsignal das obere Schwellensignal zweimal erreicht oder wenn das Messsignal größer ist als das sehr hohe Schwellensignal,
- Übergang vom zweiten Zustand in den dritten Zustand, wenn das Messsignal kleiner ist als das untere Schwellensignal,
- Übergang vom dritten Zustand in den ersten Zustand, wenn das Messsignal das untere Schwellensignal zweimal erreicht oder wenn das Messsignal kleiner ist als das sehr niedrige Schwellensignal,
- Übergang vom vierten Zustand in den ersten Zustand, wenn das Messsignal kleiner ist als das untere Schwellensignal,
- Übergang vom dritten Zustand in den zweiten Zustand, wenn das Messsignal größer ist als das obere Schwellensignal.

6. Steuerschaltung (100) nach einem der vorhergehenden Ansprüche, **dadurch gekennzeichnet, dass** die Mittel zum Vergleichen des Messsignals mit einem anderen Signal durch einen Komparator (116, 117, 118, 119) mit Hysterese gebildet sind.

7. Steuerschaltung (100) nach einem der vorhergehenden Ansprüche, **dadurch gekennzeichnet, dass** die Steuermittel und/oder die Zählmittel in einer programmierbaren Logikschaltung (115) enthalten sind.

8. Steuerschaltung (100) nach einem der vorhergehenden Ansprüche, **dadurch gekennzeichnet, dass** die Ein/Aus-Schalter MOSFET-Transistoren (111, 112, 113, 114) sind.

9. Verwendung der Steuerschaltung nach einem der vorhergehenden Ansprüche für ein elektrisches Organ, das durch eine induktive Last mit veränderlicher Induktivität gebildet ist.

10. Verwendung nach dem vorhergehenden Anspruch, **dadurch gekennzeichnet, dass** das elektrische Organ in einem Aktor enthalten ist, der für ein betätigtes Teil vorgesehen ist, wobei das elektrische Organ die Verlagerung des betätigten Teils steuert.

11. Verwendung nach dem vorhergehenden Anspruch, **dadurch gekennzeichnet, dass** der Aktor ein elektromagnetischer Ventilaktor eines Kraftfahrzeugs ist.

**Claims**

1. Circuit (100) for monitoring the current in an electrical control device (110) or the voltage across the terminals of the said electrical control device (110), the said circuit (100) comprising:

   - a bridge (101) furnished with four terminals (105, 106, 107, 108) and comprising four controlled breakers (111, 112, 113, 114),
   - a power supply source of the said bridge (109),
   - means (123) for producing a measurement signal representative of the current in the said electrical control device (110) or of the voltage across the terminals of the said electrical control device (110),
   - means (116) for comparing the said measurement signal with a high threshold signal,
   - means (117) for comparing the said measurement signal with a low threshold signal,

   the said power supply source (109) being connected between a first terminal (105) and a second terminal (106) of the said bridge (101),
   the said electrical control device (110) being connected between a third terminal (107) and fourth terminal (108) of the said bridge (101),
   the first breaker (111) being connected between the said first terminal (105) and the said third terminal (107) of the said bridge (101),
   the second breaker (114) being connected between the said first terminal (105) and the said fourth terminal (108) of the said bridge (101),
   the third breaker (113) being connected between the said third terminal (106) and the said second terminal (107) of the said bridge (101),
   the fourth breaker (112) being connected between the said fourth terminal (106) and the said second terminal (108) of the said bridge (101),
   the said monitoring circuit (100) being **characterized in that** it comprises:

   - counting means (115) for detecting the following events:

     ○ the said measurement signal attains for the second time the high threshold signal,

     ○ the said measurement signal attains for the second time the low threshold signal,

   - control means (115) for the said breakers, the said control means reacting to the monitoring signals produced by:

     ○ the said means (116) for comparing the said measurement signal with a high threshold signal,
     ○ the said means (117) for comparing the said measurement signal with a low threshold signal,
     ○ the said counting means (115)
     the said control means (115) authorizing at least three of the following four states:

   - a first state in which the said first (111) and fourth (112) breakers are closed and the said second (114) and third (113) breakers are open,
   - a second state in which the said second (114) and third (113) breakers are closed and the said first (111) and fourth (112) breakers are open,
   - at least one of the following two states:

     ○ a third state in which the said third (113) and fourth (112) breakers are closed and the said first (111) and second (114) breakers are open,
     ○ a fourth state in which the said first (111) and second (114) breakers are closed and the said third (113) and fourth (112) breakers are open.

2. Monitoring circuit (100) according to the preceding claim, **characterized in that** the said control means (115) authorize:

   - the transition of the said first state to at least one of the said third or fourth state,
   - the transition of the said second state to at least one of the said third or fourth state,
   - the transition of at least one of the said third or fourth state to the said first state,
   - the transition of at least one of the said third or fourth state to the said second state.

3. Monitoring circuit (100) according to one of the preceding claims, **characterized in that** the said control means (115) authorize the said four states, the said control means comprising means for implementing the following state machine (200):

   - transition of the said first state to the said fourth state when the said measurement signal is greater than the said high threshold signal,
   - transition of the said fourth state to the said second state when the said measurement signal attains the said high threshold signal twice,
- transition of the said second state to the said third state when the said measurement signal is less than the said low threshold signal,
- transition of the said third state to the said first state when the said measurement signal attains the said low threshold signal twice,
- transition of the said fourth state to the said first state when the said measurement signal is less than the said low threshold signal,
- transition of the said third state to the said second state when the said measurement signal is greater than the said high threshold signal.

4. Monitoring circuit (100) according to one of the preceding claims, **characterized in that** it comprises:

- means (119) for comparing the said measurement signal with a very high threshold signal greater than the said high threshold signal,
- means (118) for comparing the said measurement signal with a very low threshold signal less than the said low threshold signal,
the said control means (115) reacting to the monitoring signals produced by the said means (118, 119) for comparing the said measurement signal respectively with the said very high threshold signal and with the said very low threshold signal.

5. Monitoring circuit (100) according to the preceding claim, **characterized in that** the said control means authorize the said four states, the said control means comprising means for implementing the following state machine (200) :

- transition of the said first state to the said fourth state when the said measurement signal is greater than the said high threshold signal,
- transition of the said fourth state to the said second state when the said measurement signal attains the said high threshold signal twice or when the said measurement signal is greater than the said very high threshold signal,
- transition of the said second state to the said third state when the said measurement signal is less than the said low threshold signal,
- transition of the said third state to the said first state when the said measurement signal attains the said low threshold signal twice or when the said measurement signal is less than the said very low threshold signal,
- transition of the said fourth state to the said first state when the said measurement signal is less than the said low threshold signal,
- transition of the said third state to the said second state when the said measurement signal is greater than the said high threshold signal.

6. Monitoring circuit (100) according to one of the preceding claims **characterized in that** the said means for comparing the said measurement signal with another signal are formed by a hysteresis-type comparator (116, 117, 118, 119).

7. Monitoring circuit (100) according to one of the preceding claims, **characterized in that** the said control means and/or the said counting means are included in a programmable logic circuit (115).

8. Monitoring circuit (100) according to one of the preceding claims, **characterized in that** the said breakers are MOSFET transistors (111, 112, 113, 114).

9. Use of the monitoring circuit according to one of the preceding claims for an electrical device formed by an inductive load with variable inductance.

10. Use according to the preceding claim, **characterized in that** the electrical device is incorporated in an actuator provided with an actuated member, the said electrical device controlling in displacement the said actuated member.

11. Use according to the preceding claim **characterized in that** the said actuator is an automotive vehicle electromagnetic valve actuator.

Fig. 1

Fig. 2

Fig. 3

Magnétisation

111

VDC

112

**Fig. 4**

Démagnétisation

114

VDC

113

**Fig. 5**

Roue Libre Basse

**Fig. 6**

VDC

113 112

Roue Libre Haute

111 114

VDC

**Fig. 7**

200

Compteur_Seuil_Inf.

Compteur_Seuil_Sup.

Magnétisation

Roue libre
Haute

Compteur_Seuil_Inf.>=2

Courant > Garde_Fou_Inf.

Compteur_Seuil_Sup.>=2

Courant > Garde_Fou_Sup.

Courant > Seuil_Sup.

Courant < Seuil_Inf.

Roue libre
basse

Démagnétisation

**Fig. 8**

Fig. 9

Fig. 10

**Fig. 11**

**Fig. 12**

Fig. 13

$f$

— · — · — Contrôle de courant moyen
━━━━━━ Contrôle par hystérèsis 2 états
— — — — Contrôle par hystérèsis 3 états

$\frac{di}{dt}(t)$

## Fig. 14

$e$

$\alpha T$

$V$

$t$

Commande à 2 états

$e$

$|2\alpha-1|T$

$t$

Commande à 3 états

## Fig. 15

Courant

Seuil Sup.
Consigne
Seuil Inf.

$t$

## Fig. 16

**EP 2 553 814 B1**

## RÉFÉRENCES CITÉES DANS LA DESCRIPTION

### Documents brevets cités dans la description

- US 20050276581 A1
- FR 2876742